# EUROPEAN PATENT SPECIFICATION

(11) **EP 3 512 034 B1**
(45) Date of publication and mention of the grant of the patent: **08.09.2021**
(21) Application number: 18211799.4
(22) Date of filing: 11.12.2018
(51) Int. Cl.: H01Q 1/22, H01Q 1/44, H01Q 7/00, H01L 23/552, H01L 23/00, H01L 23/66, H04B 1/3888, H01L 21/56

(54) **ON-PACKAGE INTEGRATED STIFFENER ANTENNA**
INTEGRIERTE ON-PACKAGE-VERSTEIFUNGSANTENNE
ANTENNE DE RAIDISSEUR INTÉGRÉ SUR BOÎTIER

(30) Priority: 12.01.2018 US 201815869992
(43) Date of publication of application: 17.07.2019
(73) Proprietor: INTEL Corporation, Santa Clara, CA 95054 (US)
(72) Inventor: YONG, Khang Choong, 47100 Puchong, 10 (MY); KOH, Boon Ping, 13700 Seberang Jaya 07 (MY); GOH, Eng Huat, 10600 Penang (MY); LIM, Min Suet, 14100 Simpang Ampat (MY); SONG, Wil Choon, 11060 Bayan Lepas (MY)
(74) Representative: Müller, Stefan

(56) References cited:
- US-A1- 2007 231 962
- US-A1- 2010 026 601
- US-A1- 2016 268 213

## Description

### TECHNICAL FIELD

Embodiments described generally herein relate to microelectronic packages and microelectronic packages manufacturing. Some embodiments relate to using a package stiffening element as an antenna.

### BACKGROUND

A microelectronics package may include a transmitter, receiver, or transceiver. During operations, the transmitter, receiver, or transceiver may send and receive electromagnetic wave. The electromagnetic waves may allow the device in which the microelectronics package is contained to wirelessly communicate with other devices. Patent document US 2007/231962 A1 discloses a microelectronics package with a metallic sheet at the bottom of the package acting as stiffening element.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 illustrates a microelectronics package in accordance with embodiments disclosed herein.
FIG. 2A illustrates a stiffening element in accordance with embodiments disclosed herein.
FIG. 2B illustrates loss vs. frequency for the stiffening element in FIG. 2A.
FIG. 2C illustrates peak gain vs. frequency for the stiffening element in FIG. 2A.
FIG. 3A illustrates a stiffening element in accordance with embodiments disclosed herein.
FIG. 3B illustrates loss vs. frequency for the stiffening element in FIG. 3A.
FIG. 3C illustrates peak gain vs. frequency for the stiffening element in FIG. 3A.
FIG. 4A illustrates a stiffening element in accordance with embodiments disclosed herein.
FIG. 4B illustrates loss vs. frequency for the stiffening element in FIG. 4A.
FIG. 4C illustrates peak gain vs. frequency for the stiffening element in FIG. 4A.
FIGS. 5A and 5B illustrate microelectronics packages in accordance with embodiments disclosed herein.
FIGS. 6A and 6B illustrate a microelectronics package in accordance with embodiments disclosed herein.
FIG. 7 illustrates an example method for manufacturing a microelectronics package in accordance with embodiments disclosed herein.
FIG. 8 illustrates an example process flow for manufacturing a microelectronics package in accordance with embodiments disclosed herein.
FIG. 9A illustrates a radiation pattern for a stiffening element in accordance with embodiments disclosed herein.
FIG. 9B illustrates a return loss profile for a stiffening element in accordance with embodiments disclosed herein.
FIG. 10A illustrates single magnetic loop antenna in accordance with embodiments disclosed herein.
FIG. 10B illustrates a radiation pattern for the single magnetic loop antenna of FIG. 10A in accordance with embodiments disclosed herein.
FIG. 10C illustrates a return loss profile for the single magnetic loop antenna of FIG. 10A in accordance with embodiments disclosed herein.
FIG. 11 illustrates an example schematic of a computing device in accordance with embodiments disclosed herein.

### DETAILED DESCRIPTION

As disclosed herein, picture frame stiffening elements, or stiffeners, may be used in microelectronics packages. The stiffening element may be manufactured out of metal. The stiffening elements may cost between 15-20 cents/stiffener. The stiffeners may be used to stiffen the packages to help prevent structural warpage during use and surface mount technology (SMT) reflow.

As disclosed herein, an on-package integrated stiffener antenna (oPiS antenna), may be used to augment the picture frame stiffener with antenna attributes as an integrated wireless antenna. For example, the stiffener may be fashioned into a single, arrays, loop, patch, hybrid, etc. on-package antenna. The oPiS antenna may be used as a solution for wireless applications such as, but not limited to, 5G, Intel WiGig, Intel WiDi, wireless charging etc.

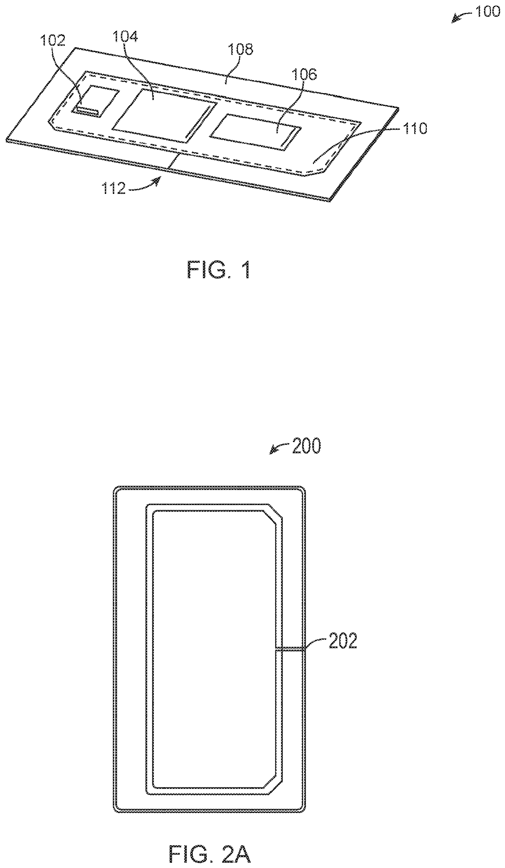

Turning now to the figures, FIG. 1 illustrates a microelectronics package 100 in accordance with embodiments disclosed herein. The microelectronics package 100 may include a radio frequency transmitter and/or receiver, (collectively referred to as transceiver 102), a platform controller hub (PCH) 104, and a central processing unit (CPU) 106. Other elements such as memory dies, additional processing dies, etc. may also be included in the microelectronics package 100. The transceiver 102, the PCH 104, the CPU 106, and other components of the package 100 may be enclosed or otherwise shielded from a stiffening element 108 by an electromagnetic interference (EMI) shield 110. The EMI shield 110 may conform to the various components of the package 100.

The stiffening element 108 may act as an antenna for the transceiver 102. For example, as disclosed herein, the stiffening element 108 may be configured to act as an antenna and a traditional antenna may be excluded from the package 100. As used herein, a traditional antenna includes a separate element that one skilled in the art would understand to be an antenna normally included with a package to allow for wireless communications.

As disclose herein, the stiffening element 108 may be manufactured from a conductive material such as a metal. The stiffening element 108 may be configured, or tuned, to have a given resonant frequency and gain. For example, the stiffening element 108 may be trimmed and shaped to have an electrical length that yields a resonant frequency of about 1,000 MHz and a peak realized gain of about 10 dB.

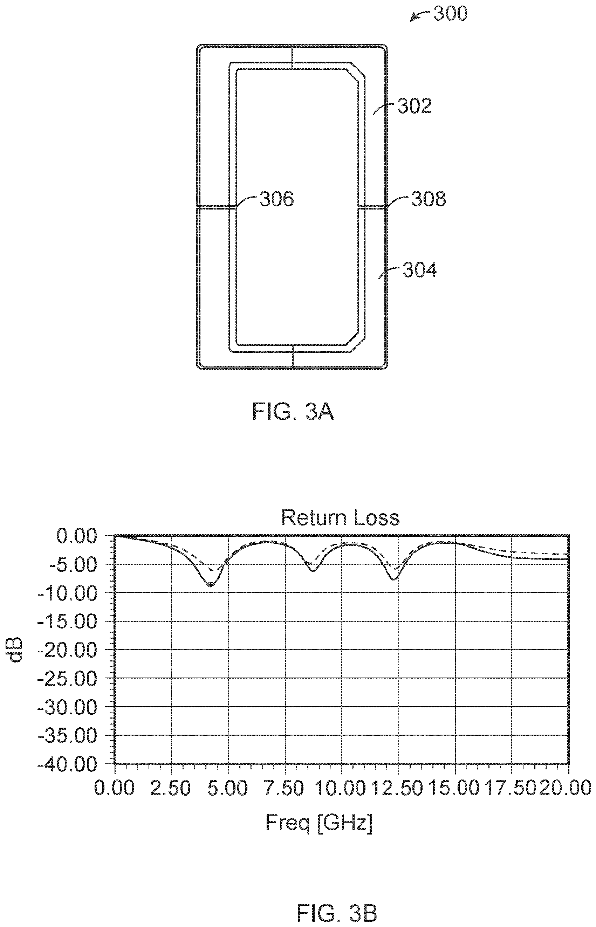

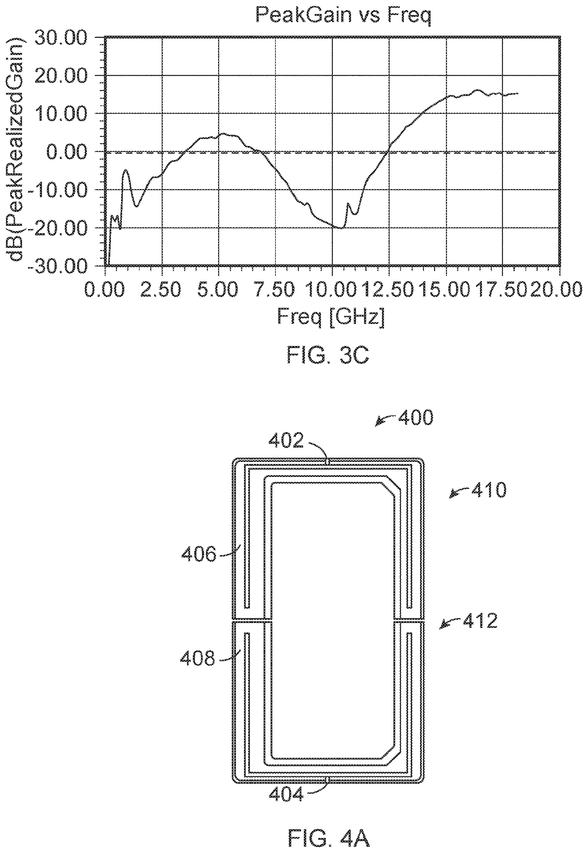

The stiffening element 108, may include a cutout 112 that may serve as an antenna feed. For example, the cutout 112 may be part of a radiating slot used to form a magnetic loop antenna as shown in FIG. 2A, an electrical dipole design as shown in FIG. 3A, and a magnetic loop design as shown in FIG. 4A.

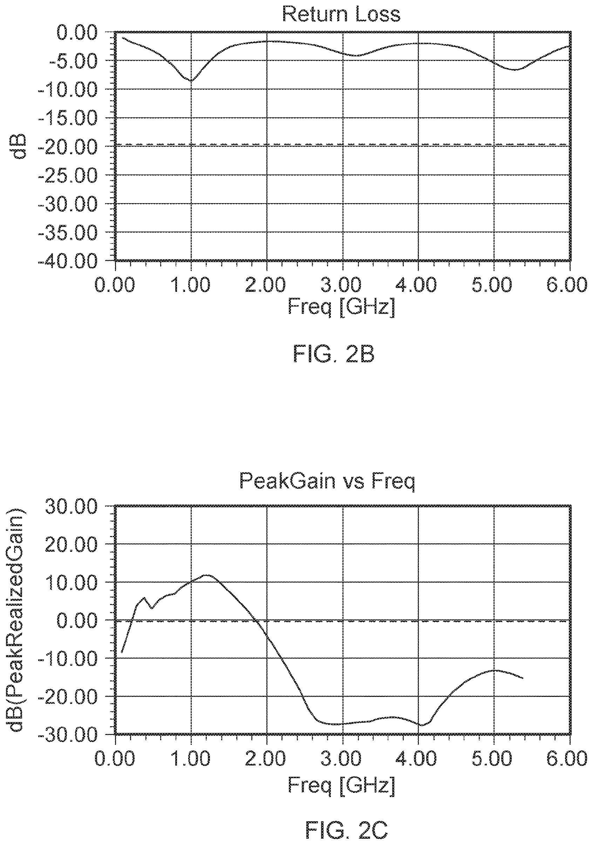

As disclosed herein, the stiffening element 108 may be optimized, or tuned, to achieve a desired resonant frequency, loss, and gain. For example, FIGS. 2B, 3B, and 4B show the return loss for the antenna designs shown in FIGS. 2A, 3A, and 4A, respectively. In addition to being tuned for a desired resonant frequency, loss, and gain, the stiffening element 108 may also be manufactured to include antenna components.

For example, as shown in FIGS. 2A, using the full perimeter length of the stiffener element 200 shown in FIG. 2A, the resonant frequency of the stiffener element 200 may be tuned to as low as 1.00 GHz and peak realized gain of 1.00GHz as illustrated in FIGS. 2B and 2C, respectively. As shown in FIG. 2A, the stiffening element 200 may include a single feeding point 202.

The stiffener element 300 shown in FIG. 3A may include a first unit 302 and a second unit 304 with feeding points 306 and 308. By having two units of half perimeter length of the stiffener element 300 shown in FIG. 3A the resonant frequency of the stiffener element 300 can be tuned to higher frequencies. In the example shown in FIG. 3A, the resonant frequency and noticeable peak realized gain starts at 4.20 GHz as shown in FIGS. 3B and 3C. While FIG. 3A shows a stiffening element 300 with the units 302 and 304 of half perimeter lengths (i.e. equal lengths), the perimeter lengths of the units 302 and 304 may be different. For example, the first unit 302 may have a quarter perimeter length and the second unit 304 may have a three quarter perimeter length.

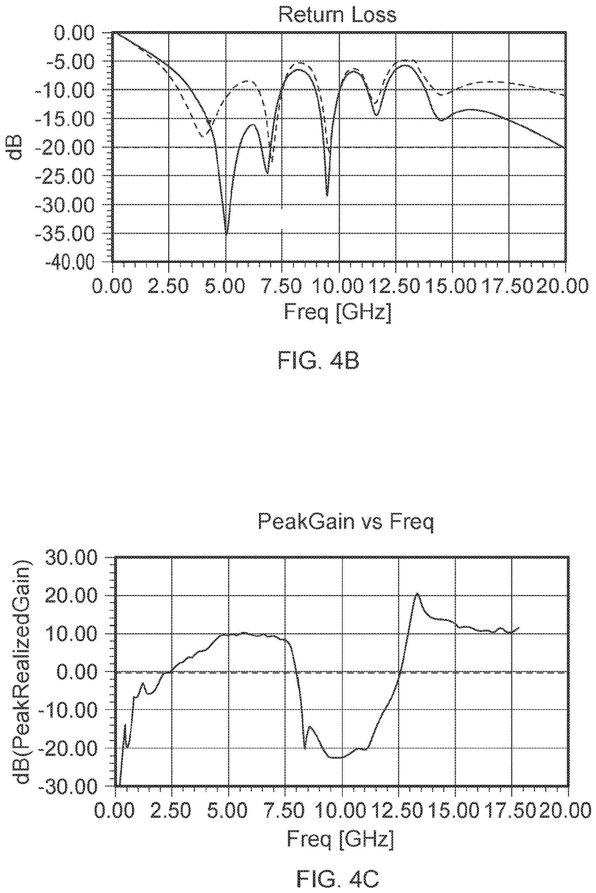

To further optimize the antenna radiation with better input impedance matching, the stiffening element 400 shown in FIG. 4A may have a magnetic loop antenna design. The feeding points 402 and 404 of the stiffening element 400 are located on the outer rings 406 and 408 of a first section 410 and a second section 412. The configuration shown in FIG. 4A may widen the bandwidth of the resonant frequency and the peak realized gain as shown in FIGS. 4B and 4C.

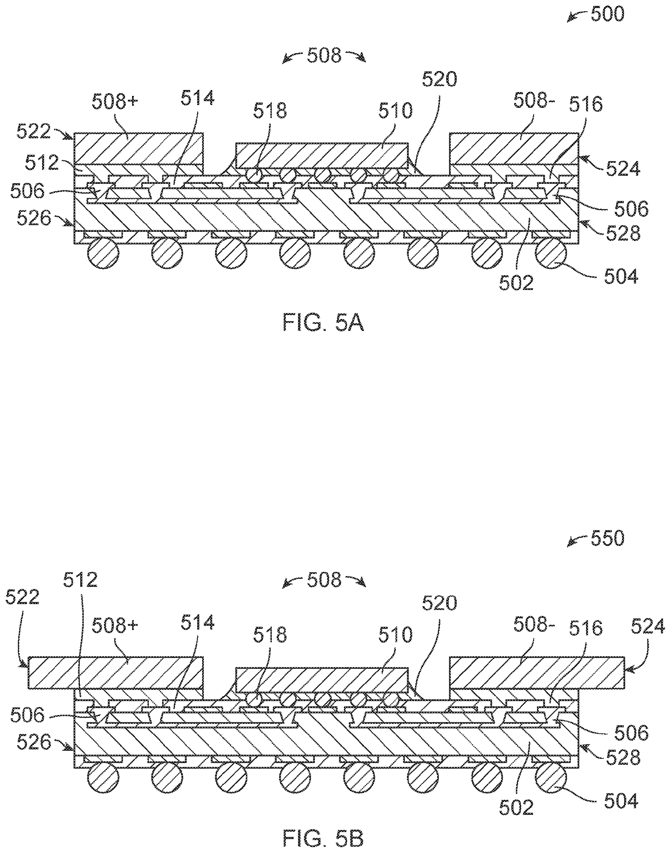

FIGS. 5A and 5B illustrate cross-sectional views of microelectronics packages 500 and 550 in accordance with embodiments disclosed herein. The microelectronics packages 500 and 550 may include a substrate 502. The substrate 502 may be attached to a printed circuit board (PCB) (not shown) via one or more solder joints 504. The substrate 502 also may include one or more vias that contain one or more feedlines 506. As disclosed herein, the feedlines 506 may be used to electrically couple a stiffening element 508 to a silicon component 510. The silicon component 510 may be a component of the transceiver 102 or electrically coupled to the transceiver 102.

As disclosed herein, the stiffening element 508 may include a positive stiffening element 508+ and a negative stiffening element 508-. The positive stiffening element 508+ and the negative stiffening element 508- may be tuned as disclosed herein. A conductive adhesive 512 may be used to secure the stiffening element 508 to the feedlines 506. The conductive adhesive 512 may rest on a solder resist layer 514 and pass to the feedlines 506 via one or more solder resist openings 516. The silicon component 510 may be coupled to the feedlines 506 via one or more solder bumps 518. An underfill 520 may be used to further secure the silicon component 510 to the solder resist layer 514.

As shown in FIG. 5A, the stiffening element 508 may be tuned and trimmed such that sidewalls 522 and 524 are flush with sidewalls 526 and 528 of the microelectronics package 500. As shown in FIG. 5B, the stiffening element 508 may be tuned and trimmed such that sidewalls 522 and 524 extend past the sidewalls 526 and 528 of the microelectronics package 550.

The stiffening element 508 extending past the sidewalls 526 and 528 may provide a larger metal area and thus allow for configuration of the electrical length of the antenna formed by the stiffening element 508. For example, the larger metal area may allow the stiffening element 508 to act as an antenna which is designed to operate at lower frequency/requires longer wavelength/requires longer electrical length to resonate. In addition, stiffening element 508 may be built using just the extension (i.e. portions extending past sidewalls 526 and 528) to resonate at higher frequency within the same stiffener length. This is due to the fact that the propagation medium for the extension (underneath the extension) is air instead of package substrate where air exhibits higher propagation velocity (i.e., shorter wavelength and requires shorter electrical length to resonate) than the package substrate. Furthermore, the medium underneath the extension can be filled with other dielectric material as another variable to configure the stiffening element 508's antenna electrical properties.

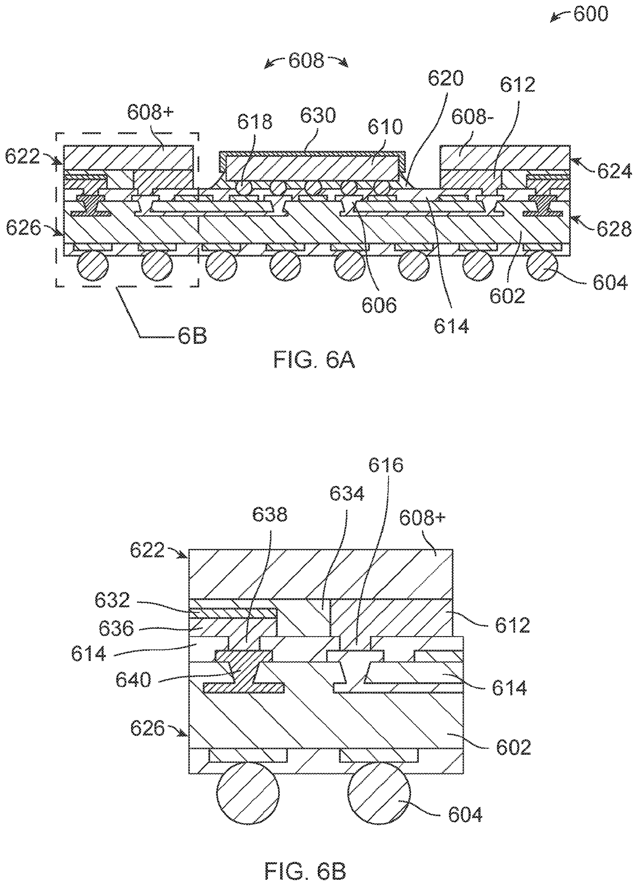

FIGS. 6A and 6B illustrates a cross-sectional view of microelectronics packages 600 in accordance with embodiments disclosed herein. The microelectronics package 600 may include a substrate 602. The substrate 602 may be attached to a printed circuit board (PCB) (not shown) via one or more solder joints 604. The substrate 602 also may include one or more vias that contain one or more feedlines 606. As disclosed herein, the feedlines 606 may be used to electrically couple a stiffening element 608 to a silicon component 610. The silicon component 610 may be a component of the transceiver 102 or electrically coupled to the transceiver 102.

As disclosed herein, the stiffening element 608 may include a positive stiffening element 608+ and a negative stiffening element 608-. The positive stiffening element 608+ and the negative stiffening element 608- may be tuned as disclosed herein. A conductive adhesive 612 may be used to secure the stiffening element 608 to the feedlines 606. The conductive adhesive 612 may rest on a solder resist layer 614 and pass to the feedlines 606 via one or more solder resist openings 616. The silicon component 610 may be coupled to the feedlines 606 via one or more solder bumps 618. An underfill 620 may be used to further secure the silicon component 610 to the solder resist layer 614.

The silicon component 610 may be surrounded on one or more sides by an EMI shield 630. The EMI shield 630 may shield the silicon component 610 from electromagnetic interference caused by the electromagnetic waves generated by or received by the stiffening element 608. In addition, the EMI shield 630 may shield the stiffening element 608 from electromagnetic interference from electromagnetic fields generated by the silicon component 610.

To assist with further shielding of the silicon component 610 and the stiffening element 608 from EMI, a metal layer 632 may be formed in between the stiffening component 610 and the substrate 602. The stiffening element 610 may be secured to the metal layer 630 via a non-conductive adhesive 634. The metal layer 632 may be secured to the solder resist layer 614 via a conductive adhesive 636. The conductive adhesive 636 may pass through a one or more vias 638 and connect the metal layer 632 to a ground layer 640. Thus, the metal layer 632 may be grounded. The metal layer 632 may isolate the stiffening element 610 from surface routing interference for EMC alleviation.

EMI shield 630 may be used to prevent electromagnetic interference from the silicon dies coupled onto the stiffening element causing unintentional radiation. The EMI shield 630 may be grounded and may be directly grounded the ground layer 640 or any other ground reference.

As shown in FIG. 6, the stiffening element 608 may be tuned and trimmed such that sidewalls 622 and 624 are flush with sidewalls 626 and 628 of the microelectronics package 600. Just as is shown in FIG. 5B, the stiffening element 608 may be tuned and trimmed such that sidewalls 622 and 624 extend past the sidewalls 626 and 628 of the microelectronics package 600.

As disclosed herein, the stiffening elements, such as stiffening elements 108, 508, and 608, may be formed into an antenna for use on microelectronics packages, such as microelectronics packages 100, 500, and 600. In other words, the stiffening elements disclosed herein may replace a traditional antenna, thus allowing microelectronics packages to be built and capable of wireless communications without the need for a separate antenna element.

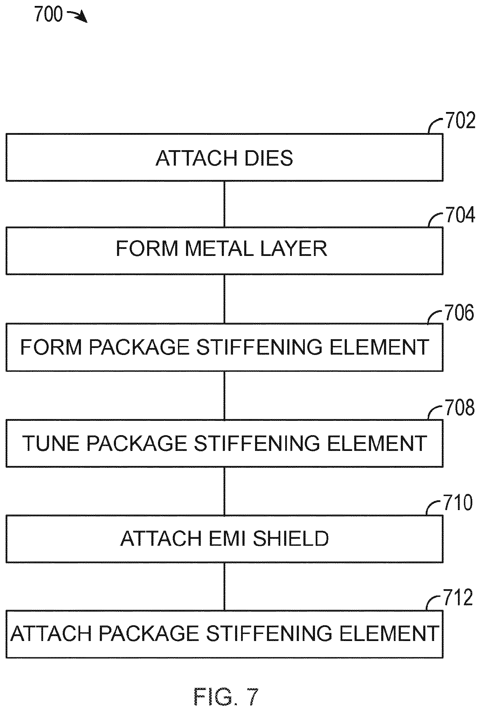

FIG. 7 illustrates an example method 700 for manufacturing a microelectronics package. The method 700 may begin at stage 702 where one or more dies may be attached to a substrate. The dies may be attached to one or more routing layers as is known in the art.

From stage 702, the method 700 may proceed to stage 704 where a metal layer may be formed. As disclosed herein, the metal layer may be formed such that a package stiffening element will be located proximate the metal layer and thus, act as a shield against magnetic interference. Also as disclosed herein, forming the metal layer can include electrically coupling the metal layer to a ground plane.

From stage 704, the method 700 may proceed to stage 706 where the package stiffening element may be formed. As disclosed herein forming the package stiffening element may include forming a cutout of a metal frame. Forming the package stiffening element may further include forming any number of antenna types. For example, the package stiffening element may be formed into a single antenna, an array loop antenna, a patch antenna, a magnetic loop antenna, or a hybrid antenna.

From stage 706, the method 700 may proceed to stage 708 where the package stiffening element may be tuned. For example, as disclosed herein, the package stiffening element may be trimmed, or tuned, to have a resonant frequency of about 1,000 MHz. The package stiffening element also may be tuned to have a peak realized gain of about 10 dB. Moreover, the package stiffening element may be tuned to have a circumference that is less than about 10% of a wavelength of a received electromagnetic waive.

From stage 708, the method 700 may proceed to stage 710 where an EMI shield may be attached. As disclosed herein, the EMI shield may cover dies, transmitters, receivers, transceivers, etc. In addition, the EMI shield may be electrically coupled to the metal layer or the ground plane. The EMI shield may be formed via sputtering techniques. Also, the EMI shield may be preformed and then bound to the dies or substrate.

From stage 710, the method 700 may proceed to stage 712 where the package stiffening element may be attached. For example, the package stiffening element may be attached to a microelectronics package and coupled to one or more of the dies such that the package stiffening element is configured to act as an antenna for a transmitter, receiver, or transceiver. As disclosed herein, the package stiffening element may be used as an antenna such that a traditional antenna need not be attached to the microelectronics package.

While the stages of the method 700 have been described in one order in this disclosure, the stages of the method 700 need not be performed in the order described herein. For example, the package stiffening element may be attached to the microelectronics package before the EMI shield is attached. In addition, the package stiffening element may be attached before the dies are attached to the substrate.

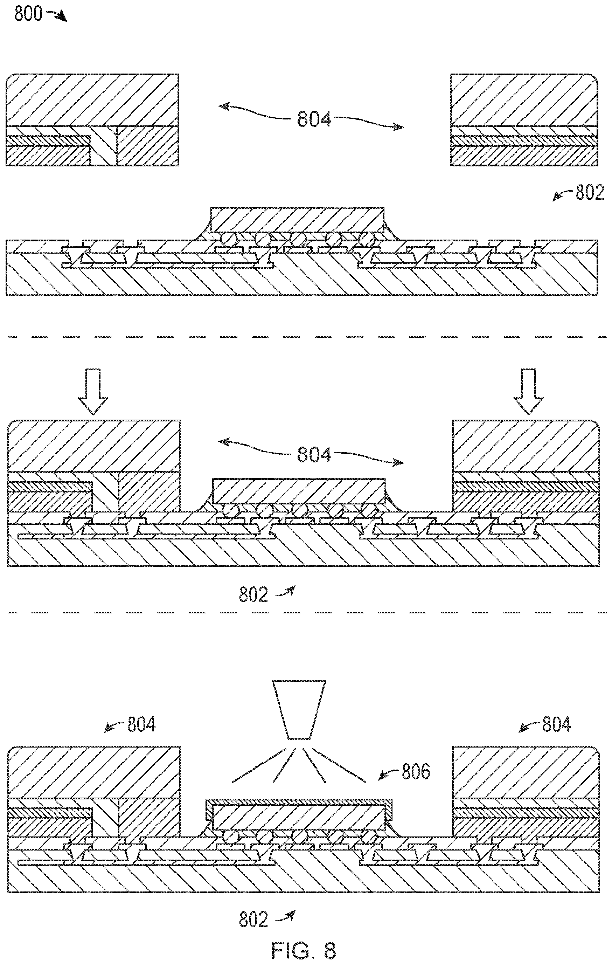

FIG. 8 shows a process flow 800 for manufacturing a microelectronics package. The process flow 800 may begin with a post assembly package 802 and a package stiffening element 804 may be received from manufacturers. The post assembly package 802 may be manufactured using known techniques and include routing layers, ground layers, metal layers, a substrate, dies, etc. as disclosed herein. The package stiffening element 804 may be received from a stiffening element manufacturer. The stiffening element manufacturer may manufacture the package stiffening element 804 as disclosed herein so that the package stiffening element is tuned to act an antenna.

Once the post assembly package 802 and the package stiffening element 804 are received, the package stiffening element 804 may be attached to the post assembly package 802. For example, as disclosed herein, a conductive adhesive or a non-conductive adhesive may be used to attach portions of the package stiffening element 804 to the post assembly package 802.

Once the package stiffening element 804 is attached to the post assembly package 802, the EMI shield 806 can be attached to the post assembly package 802. The EMI shield 806 may also be attached by the manufacturer of the post assembly package 802.

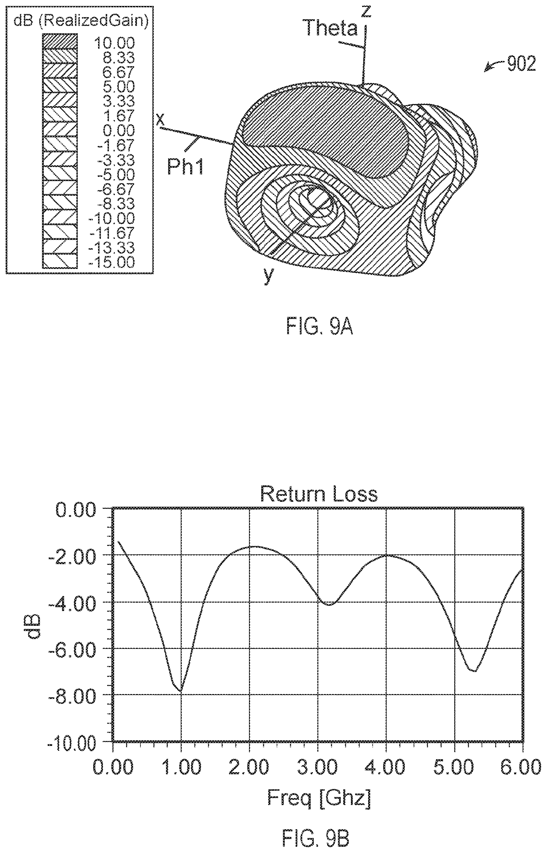

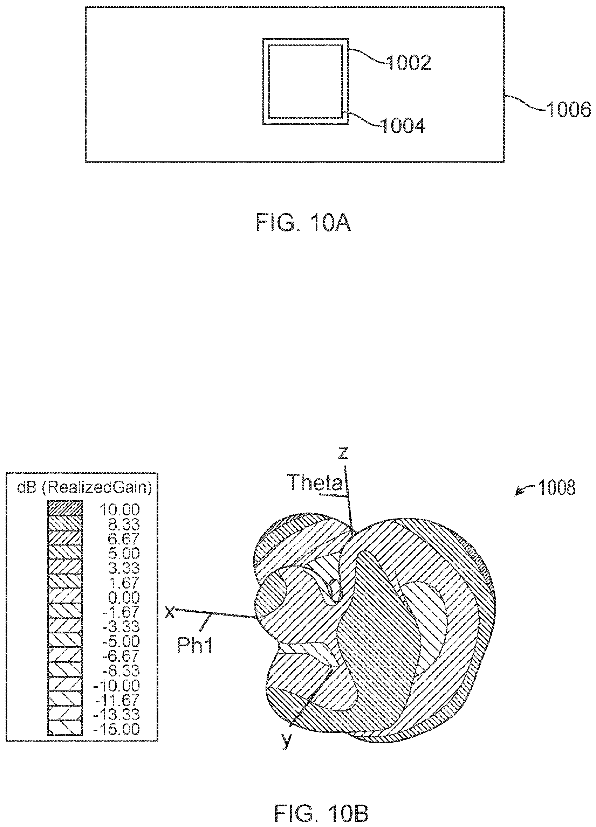

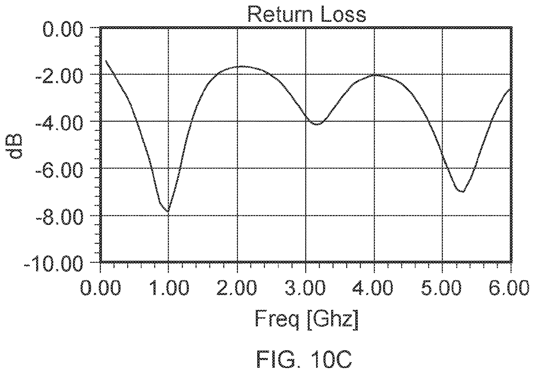

FIGS. 9A and 9B illustrate a radiation pattern 902 and a plot 904 showing return losses for a single package with a single stiffener element (i.e., the magnetic loop antenna formed by stiffening element 200) that has not been placed on a printed circuit board. In contrast, as shown in FIG. 10A, when a single package 1002 with a single stiffener element 1004 (i.e., the magnetic loop antenna formed by stiffening element 200) is soldered onto a large printed circuit board 1006, its radiation pattern 1008 is maintained in an upward facing direction and resonant frequency are still consistent despite with the presents of the large ground plane of the printed circuit board, as shown in the FIGS. 10B and 10C.

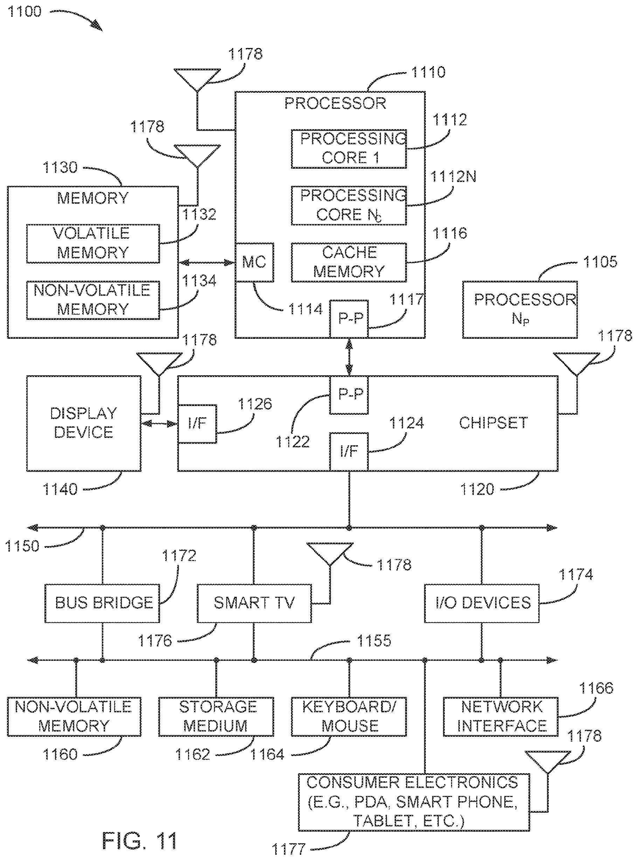

FIG. 11 illustrates a system level diagram, according to one embodiment of the invention. For instance, FIG. 11 depicts an example of an electronic device (e.g., system) including the microelectronics package disclosed herein. FIG. 11 is included to show an example of a higher level device application for the present invention. In one embodiment, system 1100 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 1100 is a system on a chip (SOC) system.

In one embodiment, processor 1110 has one or more processing cores 1112 and 1112N, where 1112N represents the Nth processor core inside processor 110 where N is a positive integer. In one embodiment, system 1100 includes multiple processors including 1110 and 105, where processor 105 has logic similar or identical to the logic of processor 1110. In some embodiments, processing core 1112 includes, but is not limited to, pre-fetch logic to fetch instructions, decode logic to decode the instructions, execution logic to execute instructions and the like. In some embodiments, processor 1110 has a cache memory 1116 to cache instructions and/or data for system 1100. Cache memory 1116 may be organized into a hierarchal structure including one or more levels of cache memory.

In some embodiments, processor 1110 includes a memory controller 1114, which is operable to perform functions that enable the processor 1110 to access and communicate with memory 1130 that includes a volatile memory 1132 and/or a non-volatile memory 1134. In some embodiments, processor 1110 is coupled with memory 1130 and chipset 1120. Processor 1110 may also be coupled to a wireless antenna 1178 to communicate with any device configured to transmit and/or receive wireless signals. In one embodiment, the wireless antenna interface 1178 operates in accordance with, but is not limited to, the IEEE 802.11 standard and its related family, Home Plug AV (HPAV), Ultra Wide Band (UWB), Bluetooth, WiMax, or any form of wireless communication protocol. In addition, as disclosed herein, the wireless antenna interface 1178 may be the stiffening elements disclosed herein.

In some embodiments, volatile memory 1132 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 1134 includes, but is not limited to, flash memory, phase change memory (PCM), read-only memory (ROM), electrically erasable programmable read-only memory (EEPROM), or any other type of non-volatile memory device.

Memory 1130 stores information and instructions to be executed by processor 1110. In one embodiment, memory 1130 may also store temporary variables or other intermediate information while processor 1110 is executing instructions. In the illustrated embodiment, chipset 1120 connects with processor 1110 via Point-to-Point (PtP or P-P) interfaces 1117 and 1122. Chipset 1120 enables processor 1110 to connect to other elements in system 1100. In some embodiments of the invention, interfaces 1117 and 1122 operate in accordance with a PtP communication protocol such as the Intel® QuickPath Interconnect (QPI) or the like. In other embodiments, a different interconnect may be used.

In some embodiments, chipset 1120 is operable to communicate with processor 1110, 1105N, display device 1140, and other devices 1172, 1176, 1174, 1160, 1162, 1164, 1166, 1177, etc. Chipset 1120 may also be coupled to a wireless antenna 1178 to communicate with any device configured to transmit and/or receive wireless signals. In addition, as disclosed herein, the wireless antenna interface 1178 may be the stiffening elements disclosed herein.

Chipset 1120 connects to display device 1140 via interface 1126. Display 1140 may be, for example, a liquid crystal display (LCD), a plasma display, cathode ray tube (CRT) display, or any other form of visual display device. In some embodiments of the invention, processor 1110 and chipset 1120 are merged into a single SOC. In addition, chipset 1120 connects to one or more buses 1150 and 1155 that interconnect various elements 1174, 1160, 1162, 1164, and 1166. Buses 1150 and 1155 may be interconnected together via a bus bridge 1172. In one embodiment, chipset 1120 couples with a non-volatile memory 1160, a mass storage device(s) 1162, a keyboard/mouse 1164, and a network interface 1166 via interface 1124 and/or 1104, smart TV 1176, consumer electronics 1177, etc.

In one embodiment, mass storage device 1162 includes, but is not limited to, a solid state drive, a hard disk drive, a universal serial bus flash memory drive, or any other form of computer data storage medium. In one embodiment, network interface 1166 is implemented by any type of well known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol. In addition, as disclosed herein, the wireless interface may be the stiffening elements disclosed herein.

While the modules shown in FIG. 11 are depicted as separate blocks within the system 1100, the functions performed by some of these blocks may be integrated within a single semiconductor circuit or may be implemented using two or more separate integrated circuits. For example, although cache memory 1116 is depicted as a separate block within processor 1110, cache memory 1116 (or selected aspects of 1116) can be incorporated into processor core 1112.

The above detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, also contemplated are examples that include the elements shown or described. Moreover, also contemplate are examples using any combination or permutation of those elements shown or described (or one or more aspects thereof), either with respect to a particular example (or one or more aspects thereof), or with respect to other examples (or one or more aspects thereof) shown or described herein.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to suggest a numerical order for their objects.

The above description is intended to be illustrative, and not restrictive. For example, the above-described examples (or one or more aspects thereof) may be used in combination with others. Other embodiments may be used, such as by one of ordinary skill in the art upon reviewing the above description. The Abstract is to allow the reader to quickly ascertain the nature of the technical disclosure and is submitted with the understanding that it will not be used to interpret or limit the scope or meaning of the claims. Also, in the above Detailed Description, various features may be grouped together to streamline the disclosure. However, the claims may not set forth features disclosed herein because embodiments may include a subset of said features. Further, embodiments may include fewer features than those disclosed in a particular example. Thus, the following claims are hereby incorporated into the Detailed Description, with a claim standing on its own as a separate embodiment. The scope of the embodiments disclosed herein is to be determined with reference to the appended claims.

## Claims

1. A microelectronics package (100, 500, 600) comprising:
a transmitter (102);
a receiver (102); one or more dies (610); and
a package stiffening element (108, 200, 300, 400) in electrical communication with the transmitter (102) and the receiver (102), the package stiffening element (108, 200, 300, 400) configured to act as an antenna for both the transmitter (102) and the receiver (102),
wherein the package stiffening element (108, 200, 300, 400) at least partially encircles the transmitter (102), the receiver (102), and one or more dies (610) forming the microelectronics package.

2. The microelectronics package of claim 1, wherein the antenna of the microelectronics package consists of the package stiffening element (108, 200, 300, 400) .

3. The microelectronics package of any one of or any combination of claims 1 and 2, wherein the package stiffening element (108, 200, 300, 400) is configured to support multiple communication types.

4. The microelectronics package of any one of or any combination of claims 1-3, wherein the package stiffening element (108, 200, 300, 400) forms a dipole antenna, an array loop antenna, or a patch antenna.

5. The microelectronics package of any one of or any combination of claims 1-3, wherein the package stiffening element (108, 200, 300, 400) forms a single antenna.

6. The microelectronics package of any one of or any combination of claims 1-4, wherein the package stiffening element (108, 200, 300, 400) is positioned along a perimeter of the microelectronics package.

7. The microelectronics package of any one of or any combination of claims 1-6, wherein the package stiffening element (108, 200, 300, 400) is bonded to the microelectronics package via a non- conductive adhesive (634).

8. The microelectronics package of any one of or any combination of claims 1-7, further comprising an electromagnetic interference shield (110) surrounding the transmitter (102) and the receiver (102), the package stiffening element (108, 200, 300, 400) encircling a portion of the electromagnetic interference shield (110).

9. The microelectronics package of any one of or any combination of claims 1-8, wherein the package stiffening element has a resonant frequency of about 1,000 MHz.

10. The microelectronics package of any one of or any combination of claims 1-9, wherein the package stiffening element (108, 200, 300, 400) comprises a first section (410), a second section (412), and feeding points (402, 404) located on outer rings (406, 408) of the first section (410) and the second section (412), wherein the package stiffening element (108, 200, 300, 400) is configured to have a peak realized gain of about 10 dB.

11. A method (700, 800) of manufacturing a microelectronics package, the method comprising:
attaching (702) a plurality of dies to a substrate;
tuning (708) a package stiffening element to have a predetermined resonate frequency;
attaching (712, 804) the package stiffening element to the substrate; and
electrically coupling the package stiffening element to at least one of the plurality of dies such that the package stiffening element is an antenna for both a transmitter and a receiver,
wherein the package stiffening element at least partially encircles the transmitter, the receiver, and the at least one of the plurality of dies.

12. The method of claim 11, further comprising forming a ground plane proximate the plurality of dies, wherein the package stiffening element is proximate a perimeter of the ground plane.

13. The method of claim 11, further comprising forming a ground plane proximate the plurality of dies, wherein the package stiffening element extends beyond a perimeter of the ground plane.

14. The method of any one of or any combination of claims 11-13, wherein tuning the package stiffening element to have the predetermined resonant frequency comprises tuning the package stiffening element to have a resonant frequency of about 1,000 MHz.

15. The method of any one of or any combination of claims 11-14, wherein tuning the package stiffening element to have the predetermined resonant frequency comprises tuning the package stiffening element to have a peak realized gain of about 10 dB.

## Patentansprüche

1. Mikroelektronisches Bauteil (100, 500, 600), umfassend:
einen Sender (102); einen Empfänger (102);
einen oder mehrere Schaltungschips (610); und
ein Bauteilversteifungselement (108, 200, 300, 400) in elektrischer Verbindung mit dem Sender (102) und dem Empfänger (102), wobei das Bauteilversteifungselement (108, 200, 300, 400) dazu eingerichtet, als Antenne sowohl für den Sender (102) als auch für den Empfänger (102) zu wirken,
wobei das Bauteilversteifungselement (108, 200, 300, 400) den Sender (102), den Empfänger (102) und einen oder mehrere Schaltungschips (610), die das mikroelektronische Bauteil bilden, mindestens teilweise umgibt.

2. Mikroelektronisches Bauteil gemäß Anspruch 1, wobei die Antenne des mikroelektronischen Bauteils aus dem Bauteilversteifungselement (108, 200, 300, 400) besteht.

3. Mikroelektronisches Bauteil gemäß einem oder einer Kombination der Ansprüche 1 und 2, wobei das Bauteilversteifungselement (108, 200, 300, 400) dazu eingerichtet ist, mehrere Kommunikationsarten zu unterstützen.

4. Mikroelektronisches Bauteil gemäß einem oder einer Kombination der Ansprüche 1-3, wobei das Bauteilversteifungselement (108, 200, 300, 400) eine Dipolantenne, eine Rahmenantennenanordnung oder eine Patchantenne bildet.

5. Mikroelektronisches Bauteil gemäß einem oder einer Kombination der Ansprüche 1-3, wobei das Bauteilversteifungselement (108, 200, 300, 400) eine einzelne Antenne bildet.

6. Mikroelektronisches Bauteil gemäß einem oder einer Kombination der Ansprüche 1-4, wobei das Bauteilversteifungselement (108, 200, 300, 400) entlang eines Umfangs des mikroelektronischen Bauteils angeordnet ist.

7. Mikroelektronisches Bauteil gemäß einem oder einer Kombination der Ansprüche 1-6, wobei das Bauteilversteifungselement (108, 200, 300, 400) mit dem mikroelektronischen Bauteil über einen nicht leitenden Klebstoff (634) verbunden ist.

8. Mikroelektronisches Bauteil gemäß einem oder einer Kombination der Ansprüche 1-7, ferner umfassend eine elektromagnetische Störungsabschirmung (110), die den Sender (102) und den Empfänger (102) umgibt, wobei das Bauteilversteifungselement (108, 200, 300, 400) einen Abschnitt der elektromagnetischen Störungsabschirmung (110) umgibt.

9. Mikroelektronisches Bauteil gemäß einem oder einer Kombination der Ansprüche 1-8, wobei das Bauteilversteifungselement eine Resonanzfrequenz von etwa 1.000 MHz aufweist.

10. Mikroelektronisches Bauteil gemäß einem oder einer Kombination der Ansprüche 1-9, wobei das Bauteilversteifungselement (108, 200, 300, 400) einen ersten Abschnitt (410), einen zweiten Abschnitt (412) und Zuführungspunkte (402, 404) umfasst, die sich an Außenringen (406, 408) des ersten Abschnitts (410) und des zweiten Abschnitts (412) befinden, wobei das Bauteilversteifungselement (108, 200, 300, 400) dazu eingerichtet ist, eine realisierte Spitzenverstärkung von etwa 10 dB aufzuweisen.

11. Verfahren (700, 800) zum Herstellen eines mikroelektronischen Bauteils, wobei das Verfahren umfasst:
Anbringen (702) einer Vielzahl von Schaltungschips auf einem Substrat;
Abstimmen (708) eines Bauteilversteifungselements auf eine vorbestimmte Resonanzfrequenz;
Anbringen (712, 804) des Bauteilversteifungselements auf dem Substrat; und
elektrisches Koppeln des Bauteilversteifungselements mit mindestens einem der Vielzahl von Schaltungschips, sodass das Bauteilversteifungselement eine Antenne sowohl für einen Sender als auch für einen Empfänger ist, wobei das Bauteilversteifungselement mindestens teilweise den Sender, den Empfänger und den mindestens einen der Vielzahl von Schaltungschips umgibt.

12. Verfahren gemäß Anspruch 11, ferner umfassend das Ausbilden einer Masseebene nahe der Vielzahl von Schaltungschips, wobei sich das Bauteilversteifungselement nahe eines Umfangs der Masseebene befindet.

13. Verfahren gemäß Anspruch 11, ferner umfassend das Ausbilden einer Masseebene nahe der Vielzahl von Schaltungschips, wobei sich das Bauteilversteifungselement über einen Umfang der Masseebene hinaus erstreckt.

14. Verfahren gemäß einem oder einer Kombination der Ansprüche 11-13, wobei das Abstimmen des Bauteilversteifungselements auf die vorbestimmte Resonanzfrequenz das Abstimmen des Bauteilversteifungselements auf eine Resonanzfrequenz von etwa 1.000 MHz umfasst.

15. Verfahren gemäß einem oder eine Kombination der Ansprüche 11-14, wobei das Abstimmen des Bauteilversteifungselements auf die vorbestimmte Resonanzfrequenz das Abstimmen des Bauteilversteifungselements auf eine realisierte Spitzenverstärkung von etwa 10 dB umfasst.

## Revendications

1. Boîtier microélectronique (100, 500, 600) comportant :
un émetteur (102) ;
un récepteur (102) ;
une ou plusieurs puces (610) ; et
un élément (108, 200, 300, 400) de raidissement de boîtier en communication électrique avec l'émetteur (102) et le récepteur (102), l'élément (108, 200, 300, 400) de raidissement de boîtier étant configuré pour agir comme une antenne à la fois pour l'émetteur (102) et le récepteur (102),
l'élément (108, 200, 300, 400) de raidissement de boîtier encerclant au moins partiellement l'émetteur (102), le récepteur (102), et une ou plusieurs puces (610) formant le boîtier microélectronique.

2. Boîtier microélectronique selon la revendication 1, l'antenne du boîtier microélectronique étant constituée de l'élément (108, 200, 300, 400) de raidissement de boîtier.

3. Boîtier microélectronique selon l'une ou une combinaison quelconque des revendications 1 et 2, l'élément (108, 200, 300, 400) de raidissement de boîtier étant configuré pour prendre en charge de multiples types de communication.

4. Boîtier microélectronique selon l'une ou une combinaison quelconque des revendications 1 à 3, l'élément (108, 200, 300, 400) de raidissement de boîtier formant une antenne à dipôle, une antenne à boucle en réseau, ou une antenne plaquée.

5. Boîtier microélectronique selon l'une ou une combinaison quelconque des revendications 1 à 3, l'élément (108, 200, 300, 400) de raidissement de boîtier formant une seule antenne.

6. Boîtier microélectronique selon l'une ou une combinaison quelconque des revendications 1 à 4, l'élément (108, 200, 300, 400) de raidissement de boîtier étant positionné le long d'un périmètre du boîtier microélectronique.

7. Boîtier microélectronique selon l'une ou une combinaison quelconque des revendications 1 à 6, l'élément (108, 200, 300, 400) de raidissement de boîtier étant collé au boîtier microélectronique via un adhésif non conducteur (634).

8. Boîtier microélectronique selon l'une ou une combinaison quelconque des revendications 1 à 7, comportant en outre un blindage antibrouillage électromagnétique (110) entourant l'émetteur (102) et le récepteur (102), l'élément (108, 200, 300, 400) de raidissement de boîtier encerclant une partie du blindage antibrouillage électromagnétique (110).

9. Boîtier microélectronique selon l'une ou une combinaison quelconque des revendications 1 à 8, l'élément de raidissement de boîtier présentant une fréquence de résonance d'environ 1000 MHz.

10. Boîtier microélectronique selon l'une ou une combinaison quelconque des revendications 1 à 9, l'élément (108, 200, 300, 400) de raidissement de boîtier comportant une première section (410), une seconde section (412), et des points (402, 404) d'alimentation situés sur des anneaux extérieurs (406, 408) de la première section (410) et de la seconde section (412), l'élément (108, 200, 300, 400) de raidissement de boîtier étant configuré pour présenter un gain réalisé de crête d'environ 10 dB.

11. Procédé (700, 800) de fabrication d'un boîtier microélectronique, le procédé comportant les étapes consistant à :
fixer (702) une pluralité de puces à un substrat ;
accorder (708) un élément de raidissement de boîtier pour présenter une fréquence de résonance prédéterminée ;
fixer (712, 804) l'élément de raidissement de boîtier au substrat ; et
coupler électriquement l'élément de raidissement de boîtier à au moins une puce de la pluralité de puces de telle façon que l'élément de raidissement de boîtier soit une antenne à la fois pour un émetteur et un récepteur, l'élément de raidissement de boîtier encerclant au moins partiellement l'émetteur, le récepteur, et la ou les puces parmi la pluralité de puces.

12. Procédé selon la revendication 11, comportant en outre la formation d'un plan de masse à proximité de la pluralité de puces, l'élément de raidissement de boîtier se trouvant à proximité d'un périmètre du plan de masse.

13. Procédé selon la revendication 11, comportant en outre la formation d'un plan de masse à proximité de la pluralité de puces, l'élément de raidissement de boîtier s'étendant au-delà d'un périmètre du plan de masse.

14. Procédé selon l'une ou une combinaison quelconque des revendications 11 à 13, l'accord de l'élément de raidissement de boîtier pour présenter la fréquence de résonance prédéterminée comportant l'accord de l'élément de raidissement de boîtier pour présenter une fréquence de résonance d'environ 1000 MHz.

15. Procédé selon l'une ou une combinaison quelconque des revendications 11 à 14, l'accord de l'élément de raidissement de boîtier pour présenter la fréquence de résonance prédéterminée comportant l'accord de l'élément de raidissement de boîtier pour présenter un gain réalisé de crête d'environ 10 dB.
